# EUROPÄISCHE PATENTANMELDUNG

(11) **EP 2 701 462 A2**
(43) Veröffentlichungstag der Anmeldung: **26.02.2014**
(21) Anmeldenummer: 13177391.3
(22) Anmeldetag: 22.07.2013
(51) Int. Cl.: H05B 33/08, B60Q 11/00, G01R 31/00, G01R 31/02

(54) **Steuergerät für elektrische Last**

(30) Priorität: 22.08.2012 DE 102012214906
(71) Anmelder: Automotive Lighting Reutlingen GmbH, 72762 Reutlingen (DE)
(72) Erfinder: Zimmermann, Sascha, 72760 Reutlingen (DE)
(74) Vertreter: DREISS Patentanwälte PartG mbB

(57) **Zusammenfassung**

Die Erfindung betrifft ein Steuergerät (40) zur elektrischen Zwischenschaltung zwischen eine Spannungsquelle (2) und eine elektrische Last (6), mit einem Plus-Eingang (12) und einem Leistungsausgang (14), mit wenigstens einer steuerbaren Lastschalteinrichtung (16), mit einer Steuergerätmasse (18), welche über einen Hauptmassezugang (20) mit der Masse (4) der Spannungsquelle verbindbar ist, und mit einer Spannungsüberwachungseinrichtung (60), welche dazu eingerichtet ist, das elektrische Potential der Steuergerätemasse (18) zu überwachen. Dabei ist ein von dem Hauptmassezugang verschiedenen Referenzmassezugang (42)und ein Spannungsteiler (46) vorgesehen, dessen Fußpunkt (52) mit dem Referenzmassezugang (42) elektrisch verbunden ist, wobei der Abgriff (54) derart mit der Spannungsüberwachungseinrichtung (60) verbunden ist, dass das elektrische Potential der Steuergerätemasse (18) durch Vergleich mit dem Potential des Abgriffs (54) überwachbar ist.

## Beschreibung

Die Erfindung betrifft ein Steuergerät zur elektrischen Zwischenschaltung zwischen eine Spannungsquelle und eine elektrische Last nach dem Oberbegriff des Anspruchs 1. Als elektrische Last kommt beispielsweise ein elektrisches Teilsystem eines Kfz (Kraftfahrzeugs), insbesondere eine Beleuchtungseinrichtung, eine Motorsteuerung oder Ähnliches in Betracht. Dementsprechend betrifft die Erfindung insbesondere ein Steuergerät für Kfz-Elektronik.

Derartige Steuergeräte sind aus der DE 44 28 115 C2 bekannt. Diese zeigt ein Steuergerät, welches mit einem Plus-Eingang einerseits und mit einem Steuergerätemasse-Zugang andererseits verbunden wird. Ferner sind Leistungsausgänge vorgesehen, über welchen das bekannte Steuergerät eine Versorgungsspannung gegenüber Masse für eine Mehrzahl von elektrischen Lasten bereitstellen kann. Der Steuergerätemasse-Zugang wird mit einem Massekontakt elektrisch verbunden. Das bekannte Steuergerät weist für jede anzuschließende Last einen Lastschalter auf, welcher mittels einer Ansteuerschaltung gezielt zwischen einer Versorgungsstellung (Verbindung von Last mit positiver Spannung) und einer Trennstellung (Last von positiver Spannungsversorgung getrennt) schaltbar ist. Die elektrischen Einrichtungen des Steuergeräts benötigen eine Energieversorgung. Diese wird über einen Versorgungsstromkreis bereitgestellt, der über die Steuergerätemasse geschlossen wird. Dies gilt insbesondere für einen als Feldeffekttransistor ausgebildeten Lastschalter, welcher eine Gate-Spannung zur Steuerung des Schaltzustandes benötigt.

Kommt es zu einer Unterbrechung oder Beeinträchtigung des Massekontakts, so liegt die Steuergerätemasse nicht mehr auf dem Massepotential. Dies kann dazu führen, dass die Lastschalter einen undefinierten Schaltzustand einnehmen. Ebenso kann es zu Störungen in der Funktion der Ansteuerschaltung des Steuergerätes kommen. Denkbar ist auch, dass der Versorgungsstromkreis anstelle über die Steuergerätemasse über die an das Steuergerät angeschlossenen Lasten geschlossen wird. Dies kann zu einer Schädigung der Lastschalter oder der sonstigen Elektronik des Steuergeräts führen.

Vor diesem Hintergrund liegt der Erfindung die Aufgabe zugrunde, ein Steuergerät für elektrische Lasten zuverlässig auf eine Beeinträchtigung oder Unterbrechung des Massekontakts für die interne Steuergerätemasse zu überwachen.

Diese Aufgabe wird durch ein Steuergerät zur elektrischen Zwischenschaltung zwischen eine Spannungsquelle und eine elektrische Last gelöst. Das Steuergerät weist einen Plus-Eingang zur elektrischen Verbindung des Steuergeräts mit einem Plus-Pol der Spannungsquelle und einem Leistungsausgang zur Verbindung des Steuergeräts mit der elektrischen Last auf, um für die Last eine elektrische Leistungsversorgung bereitzustellen. Ferner ist wenigstens eine steuerbare Lastschalteinrichtung zum Zuschalten des Plus-Pols auf die Last vorgesehen, wobei die Verbindung zu dem Plus-Pol direkt oder indirekt, das heißt über weitere elektrische Einrichtungen erfolgen kann. Außerdem ist eine Steuergerätemasse zur Bereitstellung eines internen Versorgungsstromkreises für die elektronischen Komponenten des Steuergerätes, insbesondere für die Lastschalteinrichtung vorgesehen. Zur Verbindung der Steuergerätemasse mit der Masse der Spannungsquelle weist das Steuergerät einen Hauptmassezugang auf. Ferner ist eine Spannungsüberwachungseinrichtung vorgesehen, welche dazu eingerichtet ist, das elektrische Potential der Steuergerätemasse zu überwachen.

Erfindungsgemäß weist das Steuergerät einen von dem Hauptmassezugang verschiedenen Referenzmassezugang auf. Ferner ist ein Spannungsteiler vorgesehen, welcher in der grundsätzlich bekannten Art einen elektrischen Fußpunkt, einen Abgriff und einen elektrischen Kopfpunkt aufweist. Dabei ist der Fußpunkt mit dem Referenzmassezugang elektrisch verbunden und der Abgriff derart mit der Spannungsüberwachungseinrichtung verbunden, dass das elektrische Potential der Steuergerätemasse durch Vergleich mit dem Potential des Abgriffs überwachbar ist.

Die Steuergerätemasse dient im Normalbetrieb des Steuerbetriebs nicht dazu, den Laststromkreis mit der angeschlossenen Last zu schließen. Vielmehr wird über die Steuergerätemasse der Versorgungsstromkreis für die elektrischen Komponenten des Steuergeräts geschlossen. Der Laststromkreis mit der zu versorgenden Last wird ausgehend von dem Plus-Pol der Spannungsquelle über den Plus-Eingang durch das Steuergerät, über den Leistungsausgang, über die elektrische Last zur Masse der Spannungsquelle geschlossen. Insofern weist in einer Gesamtanordnung einer zu versorgenden Last und des Steuergerätes die Last selbst einen eigenen Masseanschluss auf. Im Bereich der Kfz-Elektronik kann der Masseanschluss für die Last und/oder für die Steuergerätemasse in vorteilhafter Weise über das Fahrzeug-Chassis oder die Karosserie erfolgen.

Grundgedanke der erfindungsgemäßen Lösung ist es, bei dem Steuergerät eine Einrichtung zur Detektion einer Beeinträchtigung oder Unterbrechung der Masseanbindung bereitzustellen. Dies kann beispielsweise auftreten, wenn die Masseanbindung des Steuergeräts an die Systemmasse (zum Beispiel Fahrzeug-Chassis) unterbrochen ist, oder ein Massekontakt des Steuergeräts beispielsweise durch Korrosion beeinträchtigt ist. Wie eingangs erläutert kann dies dazu führen, dass die Lastschalteinrichtung des Steuergeräts in einen undefinierten Betriebszustand gerät oder geschädigt wird. Wesentlich ist daher, dass eine Veränderung des Potentials der Steuergerätemasse mit dem erfindungsgemäßen Steuergerät erkannt werden kann.

Die Überwachung der Steuergerätemasse erfolgt dadurch, dass das Potential der Steuergerätemasse gemessen wird. Hierzu wird mittels der Spannungsüberwachungseinrichtung das Potential der Steuergerätemasse mittelbar mit der Referenzmasse verglichen. Die Referenzmasse dient jedoch bei dem erfindungsgemäßen Steuergerät nicht unmittelbar als Referenzpotential. Vielmehr wird über den Abgriff des Spannungsteilers eine Referenzspannung gegenüber der Referenzmasse bereitgestellt. Diese Referenzspannung kann deutlich von dem Potential der Steuergerätemasse im Normalbbetrieb (Null) abweichen, so dass eine zuverlässige Überwachung möglich ist. Eine problematische Messung sehr kleiner Spannungsdifferenzen kann so vermieden werden.

Der Kopfpunkt des Spannungsteilers kann mit einer gegenüber der Referenzmasse positiven Versorgungsspannung (Vcc) beaufschlagt werden. So kann dem Abgriff ein positives Potential gegeben werden. Hierzu kann das Steuergerät einen Versorgungsspannungseingang aufweisen, über welchen dem Steuergerät die Versorgungsspannung zuführbar ist. Denkbar ist jedoch auch, dass das Steuergerät eine unabhängige interne Spannungsversorgung, insbesondere Batterie, aufweist. Dabei kann der Minuspol der Batterie mit der Referenzmasse elektrisch verbunden sein.

Die Referenzmasse muss nur einen geringen Strom führen, welcher im Wesentlichen von der Quelle der genannten Versorgungsspannung bereitgestellt wird. Dementsprechend muss die Referenzmasse nicht mit Leistungsverdrahtungen ausgelegt werden. Für den Referenzmassezugang können Anschlussdrähte mit geringem Leistungsquerschnitt und Anschlussverbindungen mit kleinen Abmessungen verwendet werden.

Die Spannungsüberwachungseinrichtung weist vorzugsweise mindestens zwei, insbesondere einen ersten und einen zweiten Messeingang auf, wobei der erste Messeingang mit dem Abgriff des Spannungsteilers und der zweite Messeingang mit der Steuergerätemasse elektrisch verbunden ist. Die Verbindung der Messeingänge, insbesondere des zweiten Messeingangs mit der Steuergerätemasse, kann unmittelbar oder mittelbar über weitere elektrische Einrichtungen erfolgen.

Die Spannungsüberwachungseinrichtung weist insbesondere auch einen Signalausgang auf. An dem Signalausgang ist ein Ausgangssignal der Spannungsüberwachungseinrichtung abgreifbar, mittels welchem ein Rückschluss auf das Potential der Steuergerätemasse gezogen werden kann. Insbesondere genügt es, wenn das Ausgangssignal derart ausgestaltet ist, dass zwischen einem Normalbetrieb (bei dem die Steuergerätemasse auf Massepotential liegt) und einem Störfall (bei dem die Steuergerätemasse ein abweichendes Potential gegenüber der Referenzmasse hat) unterschieden werden kann. Es kann jedoch auch die gemessene Potentialdifferenz als Ausgangssignal ausgebbar sein.

Die Spannungsüberwachungseinrichtung kann als Spannungsmesseinrichtung ausgebildet sein, welche derart verschaltet ist, dass die Spannung zwischen dem Abgriff des Spannungsteilers und der Steuergerätemasse messbar ist.

Denkbar ist jedoch auch, dass die Spannungsüberwachungseinrichtung einen Analog-Digital-Umsetzer aufweist. Insbesondere ist ein Messeingang des Analog-Digital-Umsetzers mit dem Abgriff des Spannungsteilers, ein anderer Messeingang mit der Steuergerätemasse verbunden. Die Verbindung kann unmittelbar oder mittelbar über weitere elektronische Bauteile erfolgen. Der Analog-Digital-Umsetzer erhält eine Energieversorgung vorzugsweise über den Versorgungsstromkreis und ist hierzu mit der Steuergerätemasse verbunden

Der Analog-Digital-Umsetzer ist insbesondere derart ausgebildet, dass an einem Ausgang des Analog-Digital-Umsetzers ein positives Signal ausgegeben wird, wenn das Potential am Abgriff des Spannungsteilers größer ist, als das Potential der Steuergerätemasse. Dieses ist im Normalbetrieb des Steuergerätes Null, das heißt der Analog-Digital-Umsetzer liefert zur Anzeige des Normalbetriebs ein positives Ausgangssignal. Denkbar ist jedoch auch, dass der Analog-Digital-Umsetzer hinsichtlich des Vorzeichens umgekehrt ausgelegt ist, das heißt, dass sein Ausgangssignal positiv ist, wenn das Potential am Abgriff des Spannungsteilers kleiner ist, als das Potential der Steuergerätemasse. Dann zeigt der Analog-Digital-Umsetzer zur Anzeige des Normalbetriebes ein Nullsignal oder, je nach Ausgestaltung, ein negatives Ausgangssignal an.

Bei Verwendung eines Analog-Digital-Umsetzers in der Spannungsüberwachungseinrichtung ist es nicht zwingend erforderlich, dass die Versorgungsspannung (Vcc) des Spannungsteilers exakt definiert ist. Es genügt eine positive (oder bei umgekehrter Auslegung entsprechend negative) Vorspannung gegenüber dem Massepotential.

Generell wandelt ein Analog-Digital-Umsetzer ein Eingangssignal, das zwischen seinen Messeingängen anliegt, in ein wertemäßig quantisiertes Ausgangssignal um, wobei die Auflösung des Ausgangssignals durch die Quantisierungsschwellwerte des Analog-Digital-Umsetzers bestimmt wird. Das Ausgangssignal des Analog-Digital-Umsetzers wechselt zwischen zwei quantisierten Werten, wenn die Spannungsdifferenz zwischen den Messeingängen einen Quantisierungsschwellwert überschreitet beziehungsweise unterschreitet. In dem erfindungsgemäßen Steuergerät kann ein Analog-Digital-Umsetzer verwendet werden, welcher eine Auflösung mit nur wenigen Quantisierungsschwellwerten aufweist. Vorzugsweise sind der Spannungsteiler, die Versorgungsspannung und der Analog-Digital-Umsetzer derart aufeinander abgestimmt, dass die Spannung des Abgriffs gegenüber der Steuergerätemasse im Normalbetrieb gerade einem Quantisierungsschwellwert entspricht. Der Normalbetrieb ist dabei der Zustand einer voll funktionsfähigen Masseanwendung, beziehungsweise der Zustand, in dem die Steuergerätemasse und die Referenzmasse auf demselben elektrischen Potential liegen.

Zur weiteren Ausgestaltung ist eine Kontrolleinrichtung zum Ansteuern der Spannungsüberwachungseinrichtung vorgesehen. Diese kann als Mikrocontroller im Steuergerät integriert sein, beispielsweise auf einer gemeinsamen Platine mit dem Analog-Digital-Umsetzer verbaut sein.

Die Kontrolleinrichtung kann die Spannungsüberwachungseinrichtung beispielsweise derart ansteuern, dass eine Überwachung beziehungsweise Messung des Potentials der Steuergerätemasse punktuell zu vorgebbaren oder vorgegebenen Zeitpunkten, insbesondere zu periodisch aufeinanderfolgenden Zeitpunkten erfolgt.

Denkbar ist jedoch auch, dass die Kontrolleinrichtung zum Ansteuern der Spannungsüberwachungseinrichtung derart ausgebildet ist, dass eine Überwachung oder Messung des Potentials der Steuergerätemasse kontinuierlich erfolgt. Dies ist insbesondere sinnvoll, wenn mit dem Steuergerät kritische Lasten mit hoher Beanspruchung, wie beispielsweise Motorsteuerung oder Zündsteuerung angesteuert werden sollen.

Die Kontrolleinrichtung wird vorzugsweise über den Versorgungsstromkreis mit Energie versorgt und ist daher mit der Steuergerätemasse verbunden.

Das Steuergerät kann außerdem weitere interne, elektrische Einrichtungen aufweisen. Sofern diese eine elektrische Energieversorgung benötigen, erfolgt dies vorzugsweise ebenfalls über den Versorgungsstromkreis. Hierzu sind die entsprechenden elektrischen Einrichtungen ebenfalls an die Steuergerätemasse angeschlossen.

Beispielsweise kann eine Hochsetzstellereinrichtung zum Hochsetzen der Spannung für die Last vorgesehen sein, welche zwischen den Plus-Eingang und den Leistungsausgang, insbesondere zwischen die Lastschalteinrichtung und den Leistungsausgang geschaltet ist. Die Zwischenschaltung kann durch unmittelbare elektrische Verbindung, jedoch auch mittelbar über weitere elektronische Einrichtungen erfolgen.

Zusätzlich oder alternativ kann eine Tiefsetzstellereinrichtung zum Heruntersetzen der Spannung vorgesehen sein. Denkbar ist auch, dass sowohl eine Hochsetzstellereinrichtung, als auch eine Tiefsetzstellereinrichtung vorgesehen sind. Diese können insbesondere in Reihe geschaltet sein. Eine solche Schaltung kann vorteilhaft beispielsweise für die Ansteuerung einer Halbleiterlichtquelle sein, da eine präzise Spannungssteuerung ermöglicht wird.

Das Steuergerät kann außerdem eine Fehlersignaleinrichtung aufweisen, mittels welcher ein Fehlersignal auslösbar ist, wenn das Potential der Steuergerätemasse von dem Potential der Referenzmasse abweicht, insbesondere dieses übersteigt. Im Normalbetrieb des Steuergerätes sind sowohl die Steuergerätemasse, als auch die Referenzmasse mit der externen Masse (Masse der Spannungsquelle), beispielsweise über das Fahrzeugchassis verbunden und liegen beide auf demselben elektrischen Potential. Im Störfall ist beispielsweise der Steuergerätemassezugang unterbrochen oder weist beispielsweise durch Oxidation einen überhöhten Übergangswiderstand auf. Dies kann dazu führen, dass die Steuergerätemasse auf einem höheren Potential liegt, als die Referenzmasse. Die Fehlersignaleinrichtung erhält als Eingangssignal insbesondere das Ausgangssignal der Spannungsüberwachungseinrichtung, welches diese an ihrem Signalausgang abgibt. Das Steuergerät kann einen Fehlersignalausgang aufweisen, über welchen im Störfall das genannte Fehlersignal abgegeben werden kann. Das Fehlersignal kann beispielsweise einer entsprechenden Anzeigeeinrichtung im Cockpit eines Fahrzeugs zugeführt werden, so dass der Fahrer des Fahrzeugs auf den Störfall hingewiesen werden kann.

Zur weiteren Ausgestaltung kann das Steuergerät eine Sicherheitsschalteinrichtung aufweisen, welche derart ausgebildet ist, dass im Betrieb des Steuergerätes eine angeschlossene Last von der elektrischen Versorgung durch die Spannungsquelle getrennt werden kann, wenn das Potential der Steuergerätemasse von dem Potential der Referenzmasse abweicht, insbesondere dieses übersteigt. Die Sicherheitsschalteinrichtung erhält insbesondere als Eingangssignal gerade das Ausgangssignal der Spannungsüberwachungseinrichtung.

Ferner kann eine Hilfsmassenschalteinrichtung vorgesehen sein, mit welcher im Störfall der genannten Art eine alternative Massenanbindung der Steuergerätemasse hergestellt werden kann.

Die Anbindung der Referenzmasse des Steuergerätes an die Masse der Spannungsquelle erfolgt vorzugsweise über einen separaten Referenzmasse-Pin. Das Steuergerät weist insbesondere einen Verbindungsstecker zur Ausbildung einer elektrischen Steckverbindung mit einem entsprechend ausgebildeten Versorgungssteckerteil auf. Verbindungsstecker und Versorgungssteckerteil sind vorzugsweise derart ausgebildet, dass bei Herstellung der Steckverbindung der Plus-Eingang des Steuergeräts mit einem Plus-Kontakt und der Hauptmassezugang des Steuergeräts mit einem Masse-Kontakt des Versorgungssteckerteils verbunden wird. Dabei weist der Verbindungsstecker vorzugsweise einen von den übrigen Kontakten separaten Referenzmassekontakt für den Referenzmassezugang des Steuergeräts derart auf, dass bei Herstellung der Steckverbindung der Referenzmassekontakt mit einem Masse-Kontakt des Versorgungssteckerteils verbunden ist.

Da über die Referenzmasse nur die vergleichsweise geringen Ströme durch den Spannungsteiler abfließen, kann der Referenzmassekontakt entsprechend kleine Abmessungen aufweisen, beispielsweise als dünner Referenzmasse-Pin ausgebildet sein.

Die Lastschalteinrichtung des Steuergeräts kann als Leistungs-Feldeffekttransistor (zum Beispiel MOS-FET) ausgebildet sein. Dabei wird die Gate-Spannung des Feldeffekttransistors beispielsweise definiert gegenüber der Steuergerätemasse angelegt. Es ist daher entscheidend, dass die Steuergerätemasse ein definiertes Nullpotential aufweist, da andernfalls eine kontrollierte Schaltung des Feldeffekttransistors nicht mehr möglich ist. Denkbar ist jedoch auch, dass die Lastschalteinrichtung als integrierter Lastschalter, insbesondere als High-Side-Driver ausgebildet ist. Auch hier ist eine Masseanbindung an die Steuergerätemasse erforderlich.

Weitere Einzelheiten und vorteilhafte Ausgestaltungen der Erfindung sind der nachfolgenden Beschreibung zu entnehmen, anhand derer die in den Figuren gezeigte Ausführungsform der Erfindung näher beschrieben und erläutert ist.

Es zeigen:
- Figur 1: Blockschaltbild eines Stromkreises mit einem Steuergerät zur Ansteuerung einer elektrischen Last, wobei das Steuergerät im Normalbetrieb arbeitet;
- Figur 2: Blockschaltbild gemäß Figur 1, wobei für das Steuergerät ein Störfall vorliegt;
- Figur 3: Blockschaltbild mit einem Steuergerät gemäß der Erfindung.

In der nachfolgenden Beschreibung sind zur besseren Übersichtlichkeit gleiche oder einander entsprechende Merkmale mit denselben Bezugszeichen versehen.

Die Figuren zeigen als Blockschaltbild je einen Stromkreis mit einer Spannungsquelle 2, welche einen Plus-Pol 3 und eine Masse 4 bereitstellt, sowie eine elektrische Last 6. Die elektrische Last 6 ist über eine externe Masseverbindung 8 mit der Masse 4 der Spannungsquelle 2 verbunden. Die externe Masseverbindung 8 kann beispielsweise durch das Fahrzeugchassis beziehungsweise die Karosserie eines Kfz bereitgestellt werden.

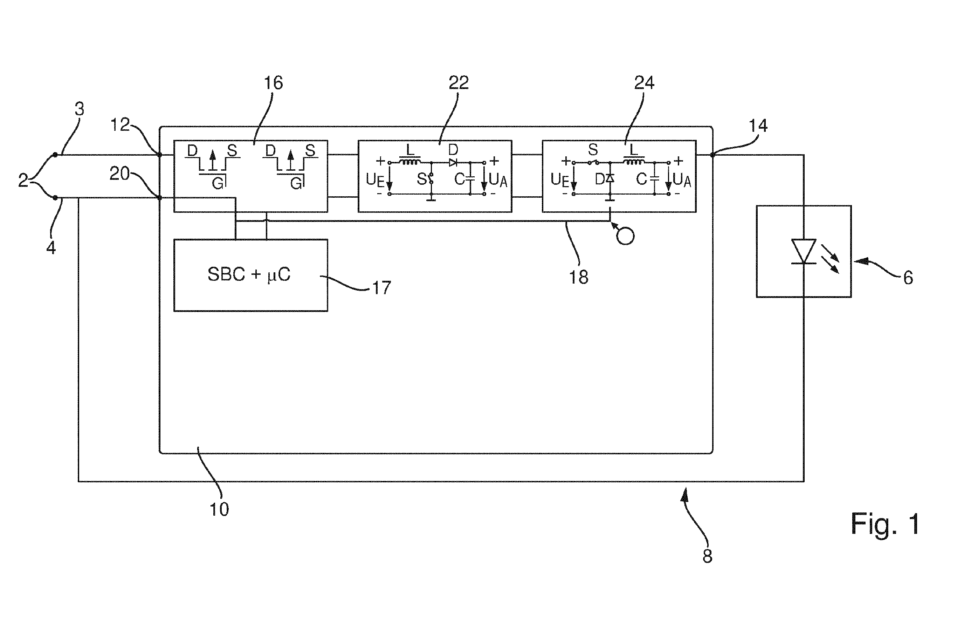

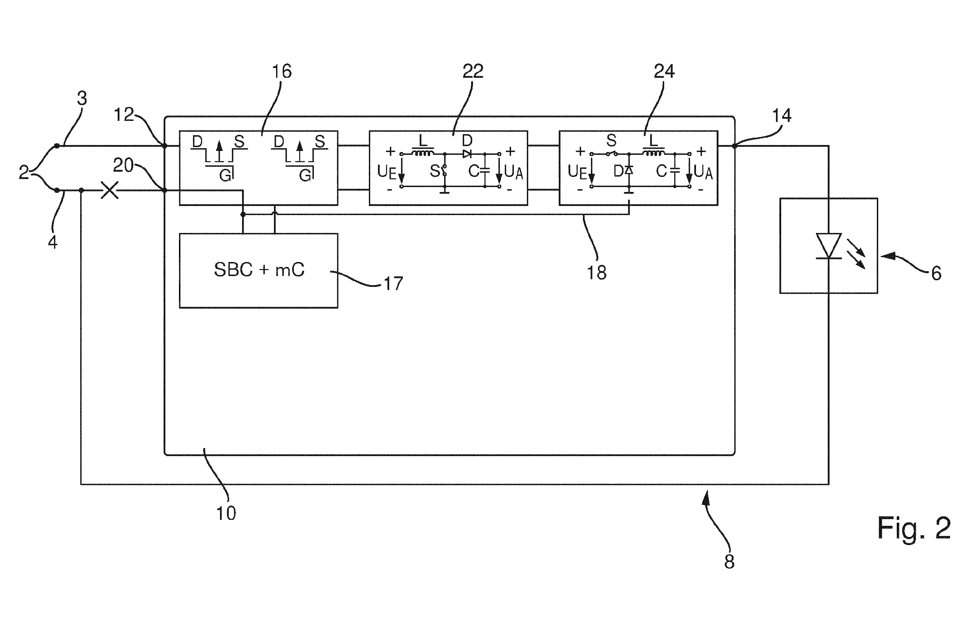

Die Figuren 1 und 2 zeigen Blockschaltbilder eines Steuergeräts 10, welches insbesondere zur Ansteuerung eines als Leistungs-LED ausgebildeten Verbrauchers (elektrische Last 6) ausgelegt ist. Anhand der Figuren 1 und 2 werden im Folgenden der Normalbetrieb des Steuergeräts 10 (Figur 1) mit funktionsfähiger Masseanbindung und ein Störfall (Figur 2) mit beeinträchtiger beziehungsweise unterbrochener Masseanbindung der Steuergerätemasse erläutert.

Das Steuergerät 10 ist zur Zwischenschaltung zwischen die Spannungsquelle 2 und die Last 6 derart ausgebildet, dass die Last 6 ein positives Betriebspotential von dem Steuergerät 10 erhält und ein externer Laststromkreis für die Last 6 über die externe Masseverbindung 8 geschlossen werden kann.

Das Steuergerät 10 hat einen Plus-Eingang 12 zur elektrischen Verbindung mit dem Plus-Pol 3 der Spannungsquelle 2. Zur Versorgung der Last 6 weist das Steuergerät 10 einen Leistungsausgang 14 auf, welcher mit der Last 6 elektrisch verbunden werden kann.

Eine der von dem Steuergerät 10 bereitgestellten Funktion besteht darin, die Last 6 kontrolliert mit elektrischer Energie zu versorgen. Hierzu weist das Steuergerät 10 eine steuerbare Lastschalteinrichtung 16 auf. Die Lastschalteinrichtung 16 umfasst wenigstens einen schaltbaren Leistungs-Feldeffekttransistor (FET), welcher derart verbaut ist, dass ein Stromfluss von der Spannungsquelle 2 zur Last 6 über ein schaltbares Kanalgebiet (Source S Drain D) des FET erfolgen kann. Zum kontrollierten Schalten der Lastschalteinrichtung 16 ist eine nicht näher dargestellte Ansteuereinrichtung 17 vorgesehen, welche beispielsweise dazu ausgebildet ist, eine Gate-Elektrode des FET (Lastschalteinrichtung 16) mit einer Gate-Spannung zum Öffnen oder Schließen des FET zu beaufschlagen.

Um die funktional elektronischen Komponenten des Steuergeräts mit Energie zu versorgen, wird in dem Steuergerät 10 ein interner Versorgungsstromkreis ausgebildet. Hierzu weist das Steuergerät 10 eine interne Steuergerätemasse 18 auf, welche über einen Hauptmassezugang 20 mit der Masse 4 der Spannungsquelle 2 verbunden werden kann.

Das Steuergerät 10 umfasst exemplarisch weitere elektrisch funktionale Baueinheiten, nämlich eine

Hochsetzstellereinrichtung 22 und eine Tiefsetzstellereinrichtung 24. Die Hochsetzstellereinrichtung 22 ist mit der Lastschalteinrichtung 16 derart in Reihe geschaltet, dass die Hochsetzstellereinrichtung 22 mit einer kontrolliert ein- und ausschaltbaren Eingangsspannung gespeist werden kann. Mittels der Hochsetzstellereinrichtung 22 kann diese Eingangsspannung in bekannter Weise kontrolliert in eine erhöhte Ausgangsspannung umgewandelt werden. Die Tiefsetzstellereinrichtung 24 ist wiederum der Hochsetzstellereinrichtung 22 in Reihe geschaltet, so dass eine wiederum kontrollierte Herabsetzung der Spannung erfolgen kann. Durch die Reihenschaltung von Hochsetzsteller und Tiefsetzsteller kann an dem Leistungsausgang 14 des Steuergeräts 10 eine kontrolliert schaltbare Ausgangsspannung zur Versorgung der Last 6 bereitgestellt werden. Die Hochsetzstellereinrichtung 22 und eine Tiefsetzstellereinrichtung 24 können vorzugsweise von der Ansteuereinrichtung 17 angesteuert werden.

Bei den weiteren elektrisch funktionalen Komponenten des Steuergeräts 10 (Hochsetzstellereinrichtung 22, Tiefsetzstellereinrichtung 24) handelt es sich wiederum um elektrische Verbraucher, welche mittels des Versorgungsstromkreises mit Energie versorgt werden und hierzu an die Steuergerätemasse 18 angebunden sind.

In dem in der Figur 1 dargestellten Normalbetrieb kann daher zwischen zwei Stromkreisen unterschieden werden. Einerseits der von Plus-Pol 3 über Steuergerät 10 über die elektrische Last 6, die externe Masseverbindung 8 zur Masse 4 geschlossene Laststromkreis. Andererseits der von Plus-Pol 3, über die elektronischen Einrichtungen 16, 17, 22, 24 jeweils zur Steuergerätemasse 18 und schließlich zur Masse 4 geschlossene Versorgungsstromkreis für die genannten elektronischen Einrichtungen.

Ist die Steuergerätemasse 18 über den Hauptmassezugang 20 mit hoher Güte mit der Masse 4 verbunden, so liegen die Steuergerätemasse 18 des internen Versorgungsstromkreises und die externe Masseverbindung 8 des Laststromkreises auf demselben Potential der Masse 4 der Spannungsquelle 2.

Ist jedoch die Anbindung der Steuergerätemasse 18 an die Masse 4 unterbrochen, beispielsweise durch einen fehlerhaften Kontakt am Hauptmassezugang 20, so liegt der in der Figur 2 skizzierte Störfall vor. Dies führt zunächst dazu, dass der Versorgungsstromkreis des Steuergeräts 10 nicht mehr (oder nicht mehr ausreichend) über die Steuergerätemasse 18 zu der Masse 4 geschlossen werden kann. In dieser Situation können daher die elektrischen Komponenten des Steuergeräts 10, insbesondere die Ansteuereinrichtung 17, die Hochsetzstellereinrichtung 22 und die Tiefsetzstellereinrichtung 24 ihre Funktionsfähigkeit verlieren. Außerdem ist denkbar, dass an der Gate-Elektrode einer als FET ausgebildeten Lastschalteinrichtung 16 eine nicht definierte Spannung anliegt, so dass die Lastschalteinrichtung 16 in einen unkontrollierten Schaltzustand gerät.

Grundsätzlich stehen die Hochsetzstellereinrichtung 22 und die Tiefsetzstellereinrichtung 24 einerseits mit der Steuergerätemasse 18, andererseits über den Leistungsausgang 14 und über die Last 6 mit der Masse 4 der Spannungsquelle 2 in Verbindung. Es ist daher denkbar, dass der interne Versorgungsstromkreis insbesondere für einzelne der elektrischen Komponenten (beispielsweise für die Ansteuereinrichtung 17) über andere elektronische Komponenten (beispielsweise über die Tiefsetzstellereinrichtung 24) und über die externe Last 6 zur Masse 4 der Spannungsquelle 2 geschlossen wird. Dies führt dazu, dass das Potential der Steuergerätemasse 18 insbesondere aufgrund der an der elektrischen Last 6 abfallenden Spannung gegenüber der externen Masse 8, 4 angehoben wird. Dies kann zu unzulässigen Betriebszuständen führen, wie beispielsweise eine fehlerhafte Versorgungsspannung der Ansteuereinrichtung 17 oder eine fehlerhafte Ansteuerung der Lastschalteinrichtung 16. Dies kann auch zu einer Zerstörung der Lastschalteinrichtung 16 führen.

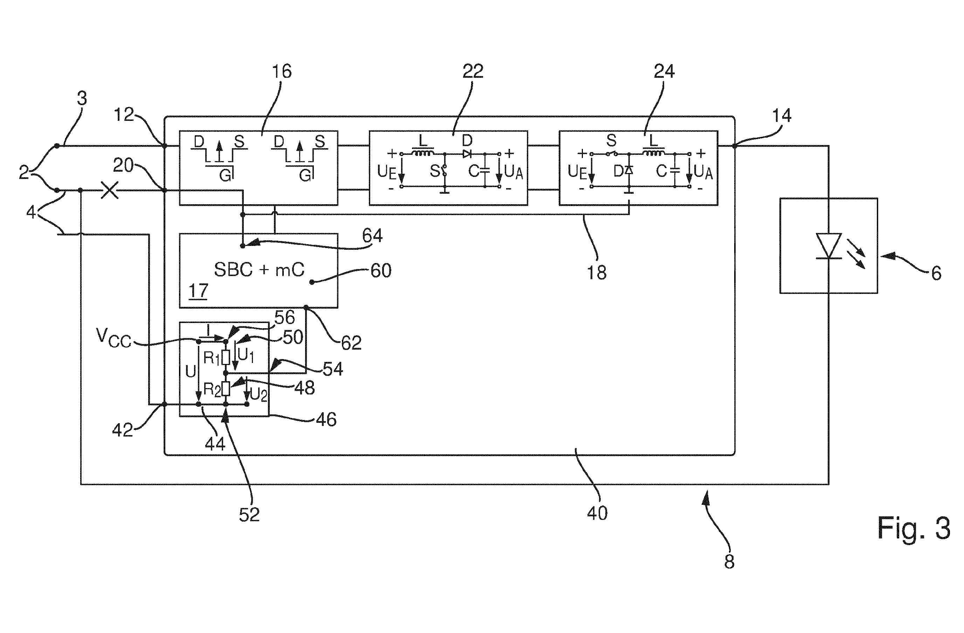

Die Figur 3 zeigt ein Blockschaltbild eines entsprechenden Stromkreises mit einem Steuergerät 40, mit welchem eine zuverlässige Überwachung dahingehend möglich ist, ob eine ausreichende Masseanbindung der Steuergerätemasse 18 an die Masse 4 vorliegt.

Das Steuergerät 40 unterscheidet sich von dem Steuergerät 10 insbesondere dadurch, dass ein von dem Hauptmassezugang 20 verschiedener Referenzmassezugang 42 vorgesehen ist, welcher eine interne Referenzmasse 44 mit einer externen Masse (insbesondere der Masse 4 der Spannungsquelle 2) verbindet.

Das Steuergerät 40 umfasst einen Spannungsteiler 46, welcher in grundsätzlich bekannter Weise einen Fußwiderstand 48 und einen Kopfwiderstand 50 aufweist, welche in Reihe geschaltet sind. Die Reihenschaltung weist einen elektrischen Fußpunkt 52 auf, welche mit der Referenzmasse 44 in leitender elektrischer Verbindung steht. Zwischen dem Fußwiderstand 48 und dem Kopfwiderstand 50 weist der Spannungsteiler 46 einen elektrischen Abgriff 54 auf. Der in der Reihenschaltung dem Fußpunkt 52 entgegengesetzte Kopfpunkt 56 des Spannungsteilers 46 ist in nicht näher dargestellter Weise mit einer Quelle für eine positive Versorgungsspannung Vcc verbunden. Daher kann an dem Abgriff 54 des Spannungsteilers 46 eine positive Referenzspannung gegenüber der Referenzmasse 44 abgegriffen werden.

Das Steuergerät 40 umfasst außerdem einen Analog-Digital-Umsetzer 60, welcher im dargestellten Beispiel in einer gemeinsamen Mikrocontroller-Einheit mit der Ansteuereinrichtung 17 verbaut ist.

Der Analog-Digital-Umsetzer 60 weist einen ersten Messeingang 62 sowie einen zweiten Messeingang 64 auf. Ferner hat der Analog-Digital-Umsetzer 60 einen nicht näher dargestellten Signalausgang, über welchen ein Ausgangssignal des Analog-Digital-Umsetzers 60 der Ansteuereinrichtung 17 zugeführt werden kann.

Der Analog-Digital-Umsetzer 60 ist derart ausgebildet, dass ein über den Signalausgang abgebbares Ausgangssignal wenigstens zwei verschiedene Ausgangswerte ("1" und "0") annehmen kann. Hierzu ist für den Analog-Digital-Umsetzer 60 wenigstens ein Quantisierungsschwellwert definiert. Der Analog-Digital-Umsetzer 60 kann dann derart ausgelegt sein, dass das Ausgangssignal den Wert "1" annimmt, wenn eine Spannungsdifferenz zwischen dem ersten Messeingang 62 und dem zweiten Messeingang 64 oberhalb des genannten Quantisierungsschwellwerts liegt. Das Ausgangssignal kann dann beispielsweise den Wert "0" annehmen, wenn die Spannungsdifferenz zwischen dem ersten Messeingang 62 und dem zweiten Messeingang 64 einen Wert unterhalb des genannten Quantisierungsschwellwerts aufweist. Insofern trägt der Analog-Digital-Umsetzer 60 zu einer Spannungsüberwachungseinrichtung bei, mittels welcher überwacht werden kann, ob die Spannungsdifferenz zwischen dem ersten Messeingang 62 und dem zweiten Messeingang 64 oberhalb des genannten Quantisierungsschwellwertes liegt.

Bei dem Steuergerät 40 ist der Abgriff 54 des Spannungsteilers 46 mit dem ersten Messeingang 62 des Analog-Digital-Umsetzers 60 verbunden. Der zweite Messeingang 64 hingegen ist mit der internen Steuergerätemasse 18 des Steuergeräts 40 verbunden. Somit kann mittels des Analog-Digital-Umsetzers 60 die Spannungsdifferenz zwischen dem Abgriff 54 des Spannungsteilers 46 und der internen Steuergerätemasse 18 durch Vergleich mit dem für den Analog-Digital-Umsetzer 60 vorgegebenen Quantisierungsschwellwert überwacht werden.

Für das Folgende wird angenommen, dass der Quantisierungsschwellwert des Analog-Digital-Umsetzers 60 auf U_{Q}= 0V (Volt) festgelegt ist. Ferner wird angenommen, dass im Betrieb der als LED ausgebildeten elektrischen Last 6 nach dem Ohm'schen Gesetz ein Spannungsabfall von wenigstens +3V (Volt) auftritt.

Für den Spannungsteiler 46 wird angenommen, dass das Verhältnis von Fußwiderstand 48 und Kopfwiderstand 50 1:5 beträgt, so dass der Spannungsteiler 46 an seinem Abgriff 54 eine Spannung bereitstellt, welche im Verhältnis 1:5 zur am Kopfpunkt 56 anliegenden Spannung Vcc steht. Beträgt die Versorgungsspannung Vcc beispielsweise +5 Volt, so liegt daher am Abgriff 54 des Spannungsteilers 46 eine Spannung von +1 Volt an.

Besteht eine voll funktionsfähige Massenanbindung der Masse 4 an die interne Steuergerätemasse 18, so liegen die Referenzmasse 44 und die interne Gerätemasse 18 auf demselben elektrischen Potential (Null). Somit entspricht die Potentialdifferenz zwischen dem Abgriff 54 und der Steuergerätemasse 18 gerade der Potentialdifferenz zwischen dem Abgriff 54 und dem Fußpunkt 52 des Spannungsteilers 46, das heißt, +1 Volt. Diese Spannungsdifferenz liegt daher zwischen dem ersten Messeingang 62 und dem zweiten Messeingang 64 an. Da diese Spannungsdifferenz über dem Quantisierungsschwellwert U_{Q}=0V des Analog-Digital-Umsetzers 60 liegt, liefert dieser an seinem Signalausgang ein Ausgangssignal mit Wert "1". Dieser Ausgangswert zeigt daher an, dass das Steuergerät 40 im Normalbetrieb arbeitet.

Ist jedoch die Masseanbindung der internen Steuergerätemasse 18 zur Masse 4 unterbrochen, wie beispielsweise in Figur 3 dargestellt, so liegt die Steuergerätemasse 18 nicht mehr auf dem Potential der Masse 4. Wie oben im Zusammenhang mit Figur 2 erläutert, ist dann denkbar, dass die Steuergerätemasse 18 aufgrund der elektrischen Verbindung (beispielsweise über die Tiefsetzstellereinrichtung 24) zur Last 6 auf einen gegenüber der externen Masseverbindung 8 angehobenen elektrischen Potential liegt. Aufgrund des Spannungsabfalls nach dem Ohm'schen Gesetz an der Last 6, ist das elektrische Potential der Steuergerätemasse 18 in der Regel höher als das Potential der Masse 4 und damit als das Potential der internen Referenzmasse 44.

Wird beispielsweise eine Potentialanhebung der Steuergerätemasse 18 aufgrund des Ohm'schen Spannungsabfalls an der Last 6 um +3 Volt angenommen, so ergibt sich folgende Situation: An dem ersten Messeingang 62 liegt gegenüber der Referenzmasse 44 (und damit gegenüber der Masse 4) eine Spannung +1 Volt an. An dem zweiten Messeingang 44 hingegen liegt aufgrund der Potentialanhebung der Steuergerätemasse 18 gegenüber der externen Masseverbindung 8 und damit gegenüber der Masse 4 eine Spannung von wenigstens +3 Volt an. Somit beträgt die Spannungsdifferenz zwischen dem ersten Messeingang 62 und dem zweiten Messeingang 64 des Analog-Digital-Umsetzers 60 in diesem Fall 1 Volt minus 3 Volt, also -2 Volt. Dieser Wert liegt unterhalb des Quantisierungsschwellwertes U_{Q}=0V des Analog-Digital-Umsetzers 60, so dass dieser als Ausgangssignal einen Ausgangswert "0" ausgibt, um so das Vorliegen eines Störfalles anzuzeigen.

Die Ansteuereinrichtung 17, welche wie erläutert das Ausgangssignal des Analog-Digital-Umsetzers 60 als Eingangssignal erhält, kann dann derart ausgestaltet sein, dass die Leistungsschalteinrichtung 16 zur Unterbrechung der Energieversorgung der elektrischen Last 6 angesteuert wird, wenn der Analog-Digital-Umsetzer 60 ein Ausgangssignal "0" liefert. Insbesondere werden in diesem Fall Leistungsschalter der Leistungsschalteinrichtung 16 geöffnet, so dass der Plus-Pol 3 der Spannungsquelle 2 von dem Versorgungsstromkreis des Steuergeräts 40 und von dem Laststromkreis mit der Last 6 getrennt ist. Damit ist es möglich, im Störfall, insbesondere bei fehlerhafter Masseanbindung des Steuergeräts 40, eine Beschädigung oder Beeinträchtigung der elektronischen Bauteile des Steuergeräts 40 und/oder der Last 6 zu vermeiden.

Das Steuergerät 40 kann außerdem eine (nicht näher dargestellte) Kontrolleinrichtung aufweisen, welche vorzugsweise ebenfalls in einer Mikrocontrollereinheit mit dem Analog-Digital-Umsetzer 60 und/oder der Ansteuereinrichtung 17 verbaut ist. Diese Kontrolleinrichtung ist dazu vorgesehen, den Analog-Digital-Umsetzer 60 derart anzusteuern, dass zu vorgebbaren Zeitpunkten ein Vergleich der Potentiale an den Messeingängen 62 und 64 erfolgt und im Störfall über die Lastschalteinrichtung 16 die Verbindung zum Plus-Pol 3 getrennt wird. Denkbar ist jedoch auch, dass die genannte Kontrolleinrichtung derart ausgebildet ist, dass eine kontinuierliche Überwachung erfolgt.

Die in der vorstehenden Beschreibung verwendeten Spannungswerte sind nur beispielhaft und können bei Bedarf durch andere Spannungswerte ersetzt werden.

## Patentansprüche

1. Steuergerät (40) zur elektrischen Zwischenschaltung zwischen eine Spannungsquelle (2) und eine elektrische Last (6),
- mit einem Plus-Eingang (12) zur elektrischen Verbindung des Steuergeräts (40) mit einem Plus-Pol (3) der Spannungsquelle (2) und einem Leistungsausgang (14) zur Verbindung des Steuergeräts (40) mit der elektrischen Last,
- mit wenigstens einer steuerbaren Lastschalteinrichtung (16) zum Zuschalten des Plus-Pols auf die Last (6),
- mit einer Steuergerätmasse (18) zur Bereitstellung eines internen Versorgungsstromkreises für das Steuergerät (40), wobei die Steuergerätemasse (18) über einen Hauptmassezugang (20) mit der Masse (4) der Spannungsquelle (2) verbindbar ist,
- und mit einer Spannungsüberwachungseinrichtung (60), welche dazu eingerichtet ist, das elektrische Potential der Steuergerätemasse (18) zu überwachen,
**gekennzeichnet durch**
- einen von dem Hauptmassezugang (20) verschiedenen Referenzmassezugang (42),
- einen Spannungsteiler (46) mit einem Fußpunkt (52), einem Abgriff (54) und einem Kopfpunkt (56),
wobei der Fußpunkt (52) mit dem Referenzmassezugang (42) elektrisch verbunden ist,
und wobei der Abgriff (54) derart mit der Spannungsüberwachungseinrichtung (60) verbunden ist, dass das elektrische Potential der Steuergerätemasse (18) **durch** Vergleich mit dem Potential des Abgriffs (54) überwachbar ist.

2. Steuergerät (40) nach Anspruch 1, **dadurch gekennzeichnet, dass** die Spannungsüberwachungseinrichtung (60) einen ersten (62) und einen zweiten Messeingang (64) aufweist, wobei der erste Messeingang (62) mit dem Abgriff (54) des Spannungsteilers (46) und der zweite Messeingang (64) mit der Steuergerätemasse (18) verbunden ist.

3. Steuergerät (40) nach Anspruch 1 oder 2, **dadurch gekennzeichnet, dass** die Spannungsüberwachungseinrichtung (60) einen Analog-Digital-Umsetzer (60) umfasst.

4. Steuergerät (40) nach Anspruch 3, **dadurch gekennzeichnet, dass** der Analog-Digital-Umsetzer (60) zumindest einen Quantisierungsschwellwert (UQ) für die Spannung zwischen den Messeingängen (62, 64) aufweist, wobei das Potential des Abgriffs (54) des Spannungsteilers (46) im Normalbetrieb des Steuergerätes (40) mit dem Quantisierungsschwellwert (UQ) übereinstimmt.

5. Steuergerät nach einem der vorherigen Ansprüche, **dadurch gekennzeichnet, dass** zum Ansteuern der Spannungsüberwachungseinrichtung (60) eine Kontrolleinrichtung vorgesehen ist, welche derart ausgebildet ist, dass eine Überwachung des Potentials der Steuergerätemasse (18) punktuell zu vorgebbaren oder vorgegebenen Zeitpunkten, insbesondere zu periodisch aufeinanderfolgenden Zeitpunkten erfolgt.

6. Steuergerät nach einem der Ansprüche 1 bis 4, **dadurch gekennzeichnet, dass** zum Ansteuern der Spannungsüberwachungseinrichtung (60) eine Kontrolleinrichtung vorgesehen ist, welche derart ausgebildet ist, dass eine Überwachung des Potentials der Steuergerätemasse (18) kontinuierlich erfolgt.

7. Steuergerät (40) nach einem der vorhergehenden Ansprüche, **dadurch gekennzeichnet, dass** eine Hochsetzstellereinrichtung (22) zum Hochsetzen der Spannung und/oder eine Tiefsetzstellereinrichtung (24) zum Heruntersetzen der Spannung vorgesehen ist, welche zwischen den Plus-Eingang (12) und den Leistungsausgang (14), vorzugsweise zwischen der Lastschalteinrichtung (16) und dem Leistungsausgang (14) geschaltet ist.

8. Steuergerät nach einem der vorhergehenden Ansprüche, **dadurch gekennzeichnet, dass** eine Fehlersignaleinrichtung vorgesehen ist, mittels welcher ein Fehlersignal auslösbar ist, wenn das Potential Steuergerätemasse (18) von dem Potential des Referenzmassezugangs (42) abweicht, insbesondere dieses übersteigt.

9. Steuergerät nach einem der vorhergehenden Ansprüche, **dadurch gekennzeichnet, dass** eine Sicherheitsschalteinrichtung vorgesehen ist, welche derart ausgebildet ist, dass im Betrieb des Steuergerätes eine angeschlossene Last (6) von dem Plus-Pol (3) der Spannungsquelle (2) elektrisch getrennt werden kann, wenn das Potential der Steuergerätemasse (18) von dem Potential des Referenzmassezugangs (42) abweicht, insbesondere dieses übersteigt.

10. Steuergerät nach einem der vorhergehenden Ansprüche, **dadurch gekennzeichnet, dass** ein Verbindungsstecker zur Ausbildung einer elektrischen Steckverbindung mit einem Versorgungssteckerteil derart vorgesehen ist, dass bei Herstellung der Steckverbindung der Plus-Eingang (12) des Steuergeräts mit einem Plus-Kontakt und der Hauptmassezugang (20) mit einem Masse-Kontakt des Versorgungssteckerteils verbunden ist, wobei der Verbindungsstecker einen von übrigen Kontakten separaten Referenzmassekontakt für den Referenzmassezugang (42) derart aufweist, dass bei Herstellung der Steckverbindung der Referenzmassekontakt mit einem Masse-Kontakt des Versorgungssteckerteils verbunden ist.
